# EUROPEAN PATENT SPECIFICATION

(11) **EP 3 537 303 B1**
(45) Date of publication and mention of the grant of the patent: **10.05.2023**
(21) Application number: 18200355.8
(22) Date of filing: 15.10.2018
(51) Int. Cl.: G06F 11/36, G06F 9/455, G06F 11/34, H03M 7/30

(54) **TRACE DATA COMPRESSION METHOD SELECTION DEVICE. METHOD, AND PROGRAM**
VERFOLGUNGSDATENKOMPRESSIONSVERFAHRENAUSWAHLVORRICHTUNG VERFAHREN UND PROGRAMM
DISPOSITIF DE SÉLECTION DE PROCÉDÉ DE COMPRESSION DE DONNÉES DE TRACE PROCÉDÉ ET PROGRAMME

(30) Priority: 20.12.2017 JP 2017243708
(43) Date of publication of application: 11.09.2019
(73) Proprietor: Renesas Electronics Corporation, 135-0061 Tokyo (JP)
(72) Inventor: TAKAHASHI, Atsushi, Koutou-ku, Tokyo 135-0061, (JP)
(74) Representative: Betten & Resch

(56) References cited:
- US-A1- 2006 242 470
- US-B1- 8 136 096
- ANDHI JANAPSATYA ET AL: "Instruction Trace Compression for Rapid Instruction Cache Simulation", DESIGN, AUTOMATION & TEST IN EUROPE CONFERENCE & EXHIBITION : NICE, FRANCE, 16 - 20 APRIL 2007, IEEE SERVICE CENTER, PISCATAWAY, NJ, 1 April 2007 (2007-04-01), pages 1-6, XP031092209, ISBN: 978-3-9810801-2-4
- A. MILENKOVIC ET AL: "Stream-Based Trace Compression", IEEE COMPUTER ARCHITECTURE LETTERS, vol. 2, no. 1, 1 January 2003 (2003-01-01) , pages 4-4, XP055591947, US ISSN: 1556-6056, DOI: 10.1109/L-CA.2003.7

## Description

### BACKGROUND

The present invention relates to a trace data compression method selection device, method, and program. For example, the present invention relates to a trace data compression method selection device, method, and program that can be used for program development in a semiconductor device in which a processor operates in accordance with a program.

Disclosed in Japanese Unexamined Patent Application Publication No. 2009-87343 is a trace circuit that generates a trace stream indicative of the activity of a monitoring target circuit in a data processing device. Japanese Unexamined Patent Application Publication No. 2009-87343 describes a configuration in which the trace circuit includes multiple compression circuits. The trace circuit compresses trace data with the compression circuits, compares the results of compression, and selects a compression circuit having a high compression effect. In addition, Japanese Unexamined Patent Application Publication No. 2009-87343 states that the compression circuits are formed of a reconfigurable device such as an FPGA (field-programmable gate array). US 8,136,096 B discloses running a simulator software executing simultaneously executable code and trace data.

US 2006/242470 A discloses a trace data compression.

The following two documents represent related art:
ANDHI JANAPSATYA et al, "Instruction Trace Compression for Rapid Instruction Cache Simulation", DESIGN, AUTOMATION & TEST IN EUROPE CONFERENCE & EXHIBITION, APRIL 2007, pages 1 - 6 A. MILENKOVIC et al, "Stream-Based Trace Compression", IEEE COMPUTER ARCHITECTURE LETTERS, January 2003, vol. 2, no. 1, pages 1 - 4

### SUMMARY

According to Japanese Unexamined Patent Application Publication No. 2009-87343, a compression circuit selection is made based on the result of analysis of trace information that is generated in real time. Japanese Unexamined Patent Application Publication No. 2009-87343 states that a test operation period is required to analyze the trace information. Therefore, if the trend of program operation of a monitoring target circuit changes, a considerable amount of time is required to cope with such changes. In recent years, in particular, MCUs (microcontroller units) designed for control may occasionally control multiple control targets at the same time. In such an instance, a running program frequently changes. If the running program changes, the data trend of resulting trace information changes. According to Japanese Unexamined Patent Application Publication No. 2009-87343, the trace information is analyzed in real time during the test operation period. Therefore, for example, immediately after a program change, trace data cannot be compressed by a compression method appropriate for the trace data.

The above problems are solved by the features of the independent claims.

According to the claimed configuration, trace data generated when a program is executed in a semiconductor device can be compressed by a compression method appropriate for the trace data.

### BRIEF DESCRIPTION OF THE DRAWINGS

FIG. 1 is a block diagram illustrating a system including a trace data compression method selection device according to a first embodiment of the present invention;
FIG. 2 is a block diagram illustrating an exemplary configuration of a compression circuit optimization section;
FIG. 3 is a flowchart illustrating an operating procedure performed by the compression circuit optimization section to determine a compression method;
FIG. 4 is a block diagram illustrating a system including a trace data compression method selection device according to a second embodiment of the present invention;
FIG. 5 is a flowchart illustrating an operating procedure performed by an MCU to debug a program; and
FIG. 6 is a timing diagram illustrating an exemplary operation of the MCU in the second embodiment.

### DETAILED DESCRIPTION

Before the explanation of embodiments of the present invention, studies conducted by the inventors of the present invention will be described. In general, hardware included in an MCU (microcontroller unit) having a trace data output function is a compression circuit that foresees effects in a versatile manner or types of preliminarily anticipated trace data such as those related to PC (program counter) transitions and RAM (random-access memory) data read/write operations with respect to internally generated trace information (trace data). Data compression methods used in a versatile manner include, for example, the output of the relative value of an address (differential output) and the omission of high-order bit values of a data value, for instance, in a case where high-order bits are unused. Another data compression method used in a versatile manner is a method of designating the range of trace target information and acquiring only necessary data within the designated range of trace information.

The trace data varies with various factors of a user environment and with a combination of options. The trend of the trace data changes depending, for example, on a program and an application used. Further, the trend of the trace data also changes with the type of data to be acquired and with a data generating block to be measured. All such conditions are not easily met by a preliminarily contemplated fixed hardware configuration.

According to Japanese Unexamined Patent Application Publication No. 2009-87343, the trace circuit includes multiple compression circuits so that multiple compression methods can be supported. Further, the multiple compression methods can be supported by adopting the compression circuits formed of a reconfigurable device. However, as mentioned earlier, Japanese Unexamined Patent Application Publication No. 2009-87343 states that a test operation period is required to analyze the trace information. Therefore, if the trend of program operation of a monitoring target circuit changes, a considerable amount of time is required to cope with such changes. Consequently, a situation where the amount of trace data is increased immediately after a change in a program may not be coped with. Moreover, according to Japanese Unexamined Patent Application Publication No. 2009-87343, compression is mainly based on the analysis of generated trace data. Therefore, algorithms concerning the correlation between neighboring data, such as the reduction of header information and similar bits, are limited.

Embodiments to which means for solving the above problems are applied will now be described in detail with reference to the accompanying drawings. In the following description and in the drawings, omissions and simplifications are made as needed for the clarification of explanation. Further, hardware for various elements depicted in the drawings as functional blocks performing various processes can be implemented by a CPU (central processing unit), a memory, or other circuit while software for such elements is implemented, for instance, by a program loaded into the memory. Therefore, it is to be understood by those skilled in the art that the functional blocks can be variously implemented by hardware only, by software only, or by a combination of hardware and software, and are not to be implemented restrictively by hardware alone or by software alone. Furthermore, like elements in the drawings are designated by the same reference numerals and will not be redundantly described.

Moreover, the above-mentioned program can be stored on various types of non-transitory computer readable media and supplied to a computer. The non-transitory computer readable media include various types of tangible recording media. Examples of the non-transitory computer readable media include a magnetic recording medium (e.g., a flexible disk, a magnetic tape, or a hard disk), a magnetooptical recording medium (e.g., a magnetooptical disk), a CD-ROM (read-only memory), a CD-R, a CD-R/W, and a semiconductor memory (e.g., a mask ROM, a PROM (programmable ROM), an EPROM (erasable PROM), a flash ROM, or a RAM) . The program may be supplied to the computer by using various types of transitory computer readable media.

Examples of the transitory computer readable media include an electrical signal, an optical signal, and an electromagnetic wave. The transitory computer readable media can supply the program to the computer through an electric wire, optical fiber, or other wired communication path or through a wireless communication path.

If necessary for convenience sake, the following description of embodiments will be divided into multiple sections or embodiments, but unless specifically stated, they are not unrelated to each other, but are in such a relation that one is, for example, an exemplary modification, an exemplary application, a detailed explanation, or a supplementary explanation of a part or the whole of the other. Further, when the number of elements (including the number of pieces, numeric values, amounts, ranges, etc.) is mentioned in the following description of embodiments, the number of elements is not limited to a specific number unless, for example, specifically stated or apparently limited to a specific number in principle. The number larger or smaller than the specific number is also applicable.

Moreover, in the embodiments described below, their elements (including, for example, operating steps) are not always indispensable unless, for example, specifically stated or apparently indispensable in principle. Similarly, when, for example, the shapes of the elements and the positional relationship therebetween are mentioned in the following description of embodiments, for example, the substantially approximate or similar shapes are included therein unless, for example, they are specifically stated or can be apparently excluded in principle. The same goes for the aforementioned number of elements (including the number of pieces, numeric values, amounts, ranges, etc.).

### First Embodiment

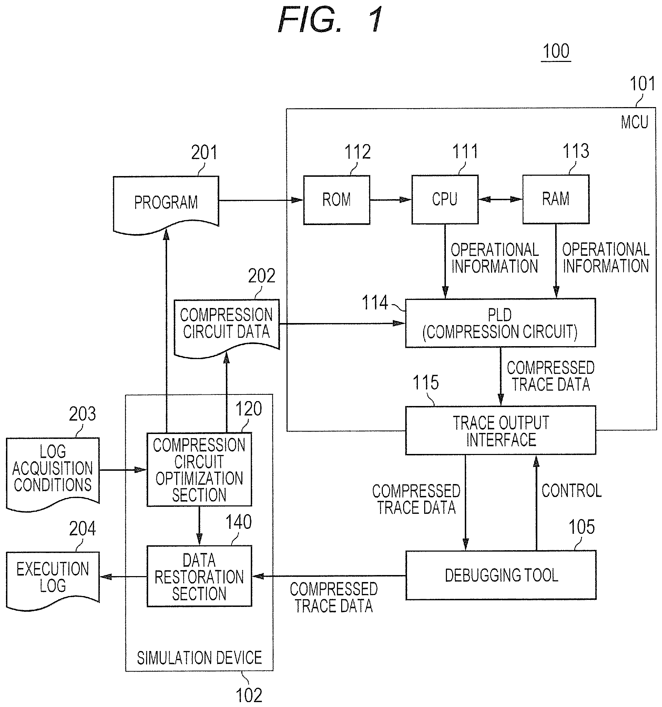

FIG. 1 illustrates a system including a trace data compression method selection device according to a first embodiment of the present invention. The system 100 includes an MCU 101, a simulation device 102, and a debugging tool 105. The simulation device 102 includes, for example, computer equipment. The MCU (semiconductor device) 101 is, for example, a microcontroller used for controlling an automobile or other control target equipment. The simulation device 102 is used when, for example, a program 201 for operating the MCU 101 is to be developed. The debugging tool 105 acquires compressed trace data from the MCU 101 when, for example, the MCU 101 is controlling equipment in accordance with the program 201. [MCU]

The MCU 101 includes a CPU 111, a ROM 112, a RAM 113, a compression circuit 114, and a trace output interface 115. The ROM 112 is a nonvolatile storage device such as a data flash and used to store data including the program 201. The CPU 111 is a processor that reads the program 201 from the ROM 112 and operates in accordance with the read program 201. When operating in accordance with the program 201, the CPU 111 stores data in the RAM 113 or reads data from the RAM 113. The MCU 101 may include, for example, a DMA circuit (DMA controller) (not depicted) that controls a DMA (direct memory access) transfer.

Operational information about the CPU 111 and/or operational information about the RAM 113 are inputted to the compression circuit 114 as trace target data (trace data). The compression circuit 114 generates compressed trace data by compressing the trace data by using a compression method selected from multiple compression methods. Here, compression is converting original data to data having a smaller data size than the original data in a restorable manner (replacing the original data with smaller-size data in a restorable manner). The trace output interface 115 outputs the compressed trace data.

Compression methods applicable to the compression circuit 114 include, for example, a method of compiling a dictionary from frequent data values and converting the frequent data values to identification numbers in the dictionary. Further, the compression methods include, for example, a method of databasing the results of simulation by the program and referencing the databased information. This method makes it possible to assign identification information to each function for management purposes, perform simulation in order to acquire data whose data order is uniquely determined, associate the acquired data with the identification information, and omit the trace data output of data whose data order is uniquely determined. Moreover, the compression methods include, for example, a method of eliminating unnecessary header information by detecting data used within range by the program 201, identifying the range of information to be outputted as a trace, and determining the bit length of necessary address information.

In the present embodiment, the compression circuit 114 is formed as a reconfigurable circuit that uses a PLD (programmable logic device) such as an FPGA. A circuit configuration of the compression circuit 114 is defined based on compression circuit data 202. The compression circuit data 202 includes configuration information for operating the reconfigurable circuit of the compression circuit 114 as a circuit for compressing the trace data.

### [Simulation Device]

The simulation device 102 is an operation analysis tool that analyzes the operation of the program 201, which runs on the MCU 101 and is to be analyzed. The simulation device 102 functions as a trace data compression method selection device that determines the compression method for trace data in the MCU 101. The simulation device 102 may be supplied together with, for example, the MCU 101 from a manufacturer of the MCU 101. Alternatively, the simulation device 102 may be supplied from a third party different from the manufacturer of the MCU 101.

The simulation device 102 includes a compression circuit optimization section 120 and a data restoration section 140. The compression circuit optimization section 120 performs simulation in accordance with the program 201 and log acquisition conditions 203, and determines the compression method of the compression circuit 114 by using the result of simulation. The MCU 101 is simulated by using, for example, an existing simulation method. Upon determining the compression method, the compression circuit optimization section 120 generates compression circuit data 202 for operating the reconfigurable circuit of the compression circuit 114 as a circuit for achieving compression by the determined compression method. Further, the compression circuit optimization section 120 reports the determined compression method to the data restoration section 140.

The debugging tool 105 acquires compressed trace data through the trace output interface 115, for example, while the program 201 is being executed by the MCU 101. The debugging tool 105 outputs the acquired compressed trace data to the data restoration section 140. The data restoration section 140 restores the compressed trace data by a restoration method compatible with the compression method of the compression circuit 114. The data restoration section 140 outputs an execution log 204 including the restored trace data to the program 201 in the MCU 101 as an execution log.

### [Compression Circuit Optimization Section]

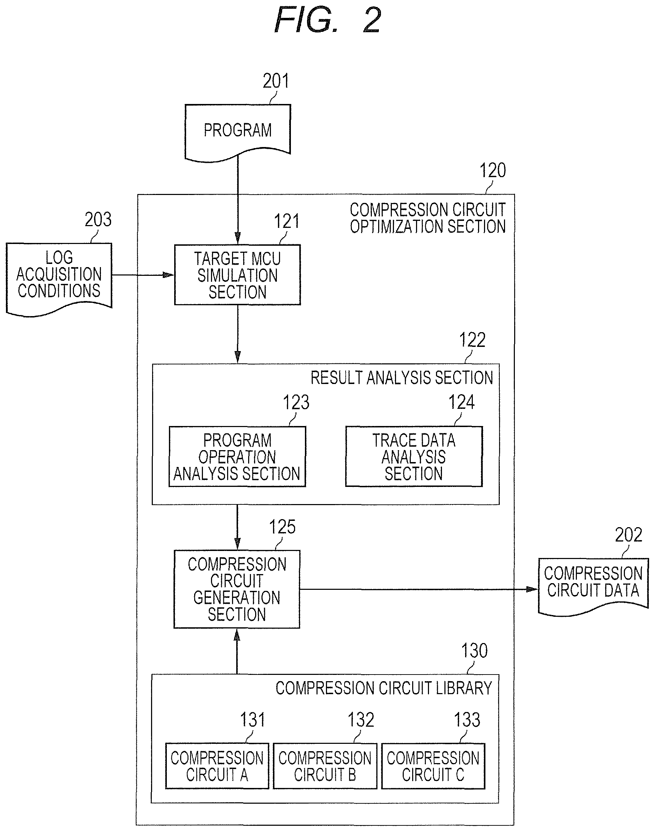

FIG. 2 illustrates the compression circuit optimization section 120. The compression circuit optimization section 120 includes a target MCU simulator section 121, a result analysis section 122, and a compression circuit generation section 125. The target MCU simulator section (simulator) 121 simulates the operation of the MCU 101, which is a target, by operating the program 201 to be analyzed. When, for example, the target MCU 101 is designated, the target MCU simulator section 121 simulates the operation of the CPU 111 mounted in the designated MCU 101. The target MCU simulator section 121 generates the result of execution of the program 201 and the result of trace data simulation. At the time of simulation, the target MCU simulator section 121 generates the result of trace data simulation in accordance with the log acquisition conditions 203. The log acquisition conditions 203 include input information that is supposed to be inputted to the MCU 101 when the MCU 101 executes the program 201.

The result analysis section 122 includes a program operation analysis section 123 and a trace data analysis section 124. The program operation analysis section 123 analyzes the result of execution of the program 201 at the time of simulation. The program operation analysis section 123 analyzes, for example, internal state transitions and sequenceability of the program 201 in accordance, for example, with the result of operation of the target MCU simulator section 121. If specific data is determined, the program operation analysis section 123 extracts a PC range within which information can be restored from only the result of simulation. Alternatively, the program operation analysis section 123 extracts, for example, data and internal addresses that are frequently encountered during the execution of the program 201.

The trace data analysis section 124 analyzes the result of trace data simulation. The trace data analysis section 124 analyzes the trace data as the result of operation, for example, of the target MCU simulator section 121 under conditions designated by the log acquisition conditions 203. The compression circuit generation section (compression method decision section) 125 determines the compression method of the compression circuit 114 (see FIG. 1) in accordance with the result of analysis of the execution of the program 201 in the result analysis section 122 and with the result of analysis of trace data simulation. The compression circuit generation section 125 determines the compression method of the compression circuit 114 by selecting a compression method having a high data reduction effect from, for example, presumed compression methods. The compression circuit generation section 125 generates the compression circuit data 202 for operating the compression circuit 114 as a circuit for compressing the trace data by the determined compression method.

A compression circuit library 130 stores basic circuit information for implementing a compression algorithm (compression method) applicable to trace data compression. The compression circuit library 130 stores configuration information about, for example, FPGAs associated with the compression methods of the compression circuit 114. The compression circuit library 130 stores, for example, compression circuit configuration information A 131 associated with compression method A, compression circuit configuration information B 132 associated with compression method B, and compression circuit configuration information C 133 associated with compression method C. The compression circuit generation section 125 acquires the configuration information associated with the determined compression method from the compression circuit library 130, and generates the compression circuit data 202. If, for example, the determined compression method is compression method A, the compression circuit generation section 125 generates the compression circuit data 202 including compression circuit configuration information A 131, which is associated with compression method A.

### [Operating Procedure]

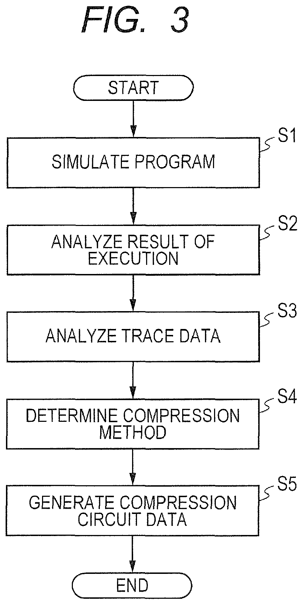

FIG. 3 illustrates an operating procedure performed by the compression circuit optimization section 120 to determine the compression method. The target MCU simulator section 121 executes the program 201 that runs on the MCU 101, and generates, in accordance with the log acquisition conditions, the result of simulation of trace data acquired from the MCU 101 during the execution of the program 201 (step S1). The program operation analysis section 123 analyzes the result of execution of the program 201 (step S2). The trace data analysis section 124 analyzes the result of trace data simulation (step S3). The compression circuit generation section 125 determines the compression method of the compression circuit in accordance with the results of analyses in steps S2 and S3 (these results are simply referred to also as the analysis results) (step S4).

In steps S2 and S3, the result analysis section 122 (the program operation analysis section 123 and the trace data analysis section 124) may check whether a specific value of trace target data is used multiple times during, for example, the execution of the program 201. The MCU 101, which provides control, often sets (stores) a specific setting in a register in order to control peripheral functions. In such an instance, a dictionary-type compression method can be applied to settings frequently used in the program. In a case where a specific value is frequently used, the compression circuit generation section 125 may, in step S4, determine, as the compression method of the compression circuit, a compression method based on a dictionary for storing a specific value and the identification information about the specific value in association with each other.

In steps S2 and S3, the result analysis section 122 may analyze the trend of the data width of trace target data that is used in a specific processing section of the program 201. Analyzing the trend of a data width used within a specific processing section, that is, a specific PC address range, makes it possible to limit, for example, a bit width required for trace data. If, for example, data is expressed by 64 bits and used in a specific processing section at a data width of 32 bits, the data amount of trace data can be reduced by changing the data width to 32 bits. When the result of analysis made by the result analysis section 122 indicates that data having a specific data width is used in a specific processing section, the result analysis section 122 reports the result of analysis to the compression circuit generation section 125. In such an instance, the compression circuit generation section 125 may, in step S4, determine, as the compression method of the compression circuit, a compression method that compresses the trace data by changing a data output width within the program counter (PC) range of the CPU 111, which corresponds to the specific processing section, in accordance with the result of analysis of the trend of data width.

The result analysis section 122 may, in steps S2 and S3, analyze whether a specific amount of trace target data is successively used in a specific processing section of the program 201. In a case where a specific amount of data is successively used in a specific processing section, compressing successive pieces of data to a single piece of data by using a compression algorithm useful for data larger in amount than a predetermined amount of data reduces the data amount to an amount smaller than when individual pieces of data are separately outputted as trace data. When the result of analysis made by the result analysis section 122 indicates that a specific amount of data is successively used in a specific processing section, the result analysis section 122 reports the result of analysis to the compression circuit generation section 125. In such an instance, the compression circuit generation section 125 may, in step S4, determine, as the compression method of the compression circuit, a compression method of compressing the trace data by compressing the specific amount of data by using a predetermined compression algorithm.

The result analysis section 122 may, in steps S2 and S3, analyze whether the operation in a specific processing section of the program 201 is unique. If the operation is unique, information within the specific processing section is equivalent to the result of simulation. Therefore, the output of the information as a trace can be omitted. In the case of a branch, for example, only the result of branch determination may be outputted, and the other information can be reduced. As regards data, information used outside the MCU 101, such as only external communication information and timing information, may be outputted, and the other information can be reduced. When the result of analysis made by the result analysis section 122 indicates that the operation in the specific processing section is unique, the result analysis section 122 reports the result of analysis to the compression circuit generation section 125. In such an instance, the compression circuit generation section 125 may, in step S4, determine, as the compression method of the compression circuit, a compression method of compressing the trace data by omitting the trace data output of information within the specific processing section.

The result analysis section 122 may, in steps S2 and S3, determine whether a timestamp to be added to the trace data can be omitted at a time point other than a time point matching predetermined conditions. In a case where a timestamp needs to be acquired only at a specific time point, information should be outputted only under a designated condition such as a specific memory address or a specific PC address, and timestamps representing the other time points can be reproduced by simulation. If the result of determination made by the result analysis section 122 indicates that the timestamp can be omitted, the result analysis section 122 reports the result of determination to the compression circuit generation section 125. In such an instance, the compression circuit generation section 125 determines, in step S4, as the compression method of the compression circuit, a compression method of compressing the trace data by omitting a timestamp at a time point other than a time point matching the predetermined conditions.

By using, for example, the above-described method and the result of simulation, the compression circuit generation section 125 selects a compression method for producing a high compression effect on the trace data in the compression circuit 114 of the MCU 101, and determines the selected compression method as the compression method of the compression circuit. The compression circuit generation section 125 generates the compression circuit data 202 that is used to operate an FPGA or other PLD included in the compression circuit 114 as a circuit for compressing the trace data by the compression method determined in step S4 (step S5). In step S5, the compression circuit generation section 125 determines the compression method and its parameters in accordance with the result of analysis of simulation, and generates the compression circuit data 202 including circuit configuration information and parameters.

Alternatively, in step S4, the compression circuit generation section 125 may determine to apply different compression methods to two or more different processing sections. For example, the compression circuit generation section 125 may determine to apply a dictionary-based compression method to one processing section and apply, to another processing section, an algorithm-based compression method of compressing a specific amount of data. In such an instance, the compression circuit data 202 may include multiple pieces of configuration information associated with two or more different compression methods. When the program 201 is being executed by the MCU 101, the compression circuit 114 may switch from one compression method to another in accordance, for example, with the PC address. The number of compression methods available to the compression circuit 114 depends, for example, on the number of gates of an FPGA used in the compression circuit 114.

### [Data Restoration]

The compression circuit generation section 125 reports the compression method determined in step S4 to the data restoration section 140. When the program 201 is being executed by the MCU 101, the data restoration section 140 acquires, through the debugging tool 105, the compressed trace data compressed by the compression circuit 114. The data restoration section 140 performs a restoration process on the compressed trace data by using a restoration method compatible with the compression method and parameters set for the compression circuit 114, and generates an execution log 204. When the data restoration section 140 performs the restoration process, the compressed trace data is restored to information having a granularity that can be confirmed by a user. If, for example, data in a unique processing section is omitted at the time of data restoration, simulation may be performed again to acquire the omitted data from the result of simulation and incorporate the acquired omitted data into the execution log 204.

### [Summary]

In the present embodiment, the compression circuit optimization section 120 performs simulation on the program 201 that runs on the MCU 101, and analyzes, for example, the trend of the generated trace data. By performing simulation, for example, the trend of the trace data generated in the MCU 101 can be grasped in the present embodiment before the MCU 101 actually runs the program 201. In the MCU 101, the compression circuit 114 is configured so as to be able to compress the trace data by a compression method selected from multiple compression methods. Based, for example, on the trend of the trace data generated in the MCU 101, the compression circuit optimization section 120 determines the compression method to be used for compression in the compression circuit 114. In this manner, the trace data generated upon execution of the program 201 can be compressed in the MCU 101 by a compression method appropriate for the trace data. Reducing the data amount of the compressed trace data outputted from the trace output interface 115 makes it possible to avoid a situation where some trace data is not acquired due to bandwidth insufficiency of the trace output interface 115.

In the present embodiment, a reconfigurable circuit, such as an FPGA, is used in the compression circuit 114. As the reconfigurable circuit is used in the compression circuit 114, the compression method of the compression circuit 114 can be changed in accordance with the compression circuit data 202. In the present embodiment, as the compression method of the compression circuit 114 can be selected in accordance with the compression circuit data 202, a user developing the program 201 can change the compression method for the trace data in accordance, for example, with the characteristics of the program 201 executed by the MCU 101. Based on the program and the acquired trace data, the compression method of the compression circuit 114 can be selected in the present embodiment by an optimization method optimized, for example, for a multi-core or a single core. Further, a compression method of the compression circuit 114 can be selected in the present embodiment by an optimization method optimized for gaining data access, PC acquisition, or a specific control pattern.

For example, a compression circuit capable of compressing data having a preliminarily-anticipated common data pattern is mounted in a common MCU. In such an instance, the compression circuit uses a fixed compression method. Therefore, a trace data compression effect on the execution of one program is high, but the trace data compression effect on the execution of another program is low. Further, if the data amount of trace data to be acquired is large, the user needs to reduce the number of acquisition targets or perform setup in consideration of trace data generated in the MCU. In such an instance, the acquisition of trace data is highly difficult, and it is necessary to actually operate the MCU for confirmation purposes and verify whether the trace data can be acquired. Meanwhile, the present embodiment makes it possible to estimate the data amount of trace data beforehand by performing simulation and perform setup while predicting the amount of information to be generated. This decreases the difficulty of trace data acquisition. Further, as data restoration is achieved by simulation, the amount of compressed trace data to be outputted can be minimized, and data not covered by the compressed trace data can be acquired from simulation.

### Second Embodiment

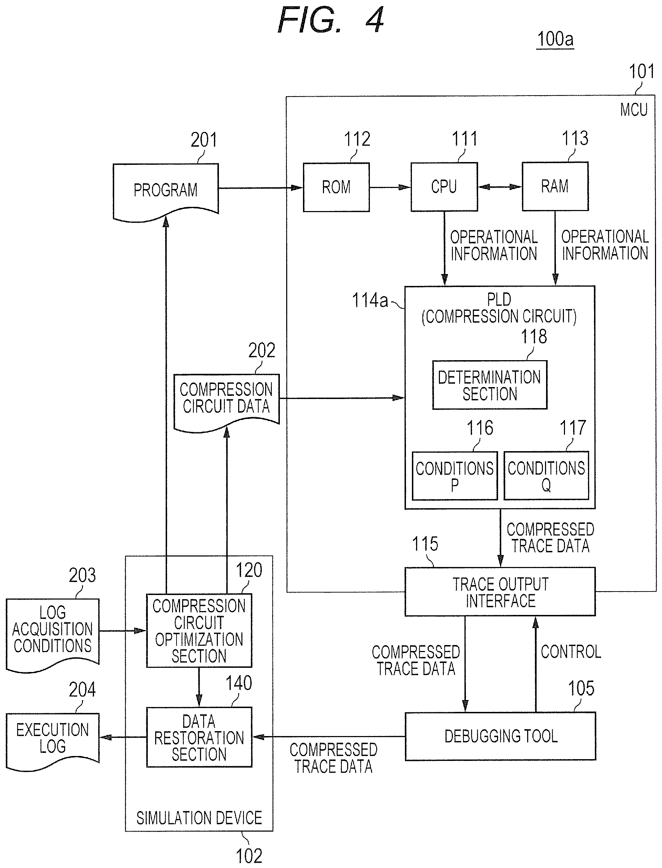

A second embodiment of the present invention will now be described. FIG. 4 illustrates a system including the trace data compression method selection device according to a second embodiment of the present invention. This system 100a includes an MCU 101a and differs in MCU configuration from the system 100 described in conjunction with the first embodiment depicted in FIG. 1. In the second embodiment, the trace data includes two types of data. The two types of trace data differ, for example, in the importance of data. A compression circuit 114a of the MCU 101a includes a compression circuit 116 and a compression circuit 117. The compression circuit 116 compresses one type of trace data. The compression circuit 117 compresses the other type of trace data. Further, the compression circuit 114a includes a determination section 118. The other elements may be the same as those in the first embodiment.

In the second embodiment, multiple sets of the log acquisition conditions 203 are to be specified as trace data generation (acquisition) conditions. The trace data acquisition conditions include, for example, conditions P and conditions Q. Conditions P denote conditions for designating trace data that is to be definitely acquired. Conditions Q denote conditions for designating trace data that is to be acquired wherever possible. The compression circuit 116 is a compression circuit (circuit portion) for compressing highly important trace data designated by conditions P. The compression circuit 117 is a compression circuit (circuit portion) for compressing lowly important trace data designated by conditions Q. The compression circuits 116, 117 are implemented by a reconfigurable circuit such as an FPGA. For the sake of convenience, trace data designated by conditions P and compressed by the compression circuit 116 is hereinafter referred to also as the Must data, and trace data designated by conditions Q and compressed by the compression circuit 117 is hereinafter referred to also as the Want data.

Under normal conditions, the compression circuits 116, 117 respectively compress the associated types of trace data, and the trace output interface 115 outputs compressed Must data and Want data. The determination section 118 determines whether conditions for stopping the output of Want data are established. The circuit configuration of the determination section 118 and determination conditions applied to the determination section 118 are specified by the compression circuit data 202. When the determination section 118 determines that the determination conditions are established, the determination section 118 inhibits Want data compressed by the compression circuit 117 from being outputted from the trace output interface 115 to the debugging tool 105. In this instance, the trace output interface 115 outputs compressed Must data to the debugging tool 105.

In the present embodiment, the target MCU simulator section 121 (see FIG. 2) generates a Must data simulation result and a Want data simulation result. The result analysis section 122, for example, analyzes Must data and Want data. The compression circuit generation section 125 determines the compression method of the compression circuit 116 in accordance with the result of analysis of the execution of the program 201 and with the result of analysis of Must data simulation. Further, the compression circuit generation section 125 determines the compression method of the compression circuit 117 in accordance with the result of analysis of the execution of the program 201 and with the result of analysis of Want data simulation.

The result analysis section 122 further determines whether the amount of Must data generation per unit time in a specific processing state is not smaller than a threshold value. When the result analysis section 122 determines that the amount of Must data generation per unit time in a specific processing state is not smaller than the threshold value, the result analysis section 122 reports such a result of determination to the compression circuit generation section 125. In this instance, the compression circuit generation section 125 further generates determination conditions associated with the specific processing state where the amount of Must data generation per unit time is not smaller than the threshold value. In the present embodiment, the compression circuit generation section 125 doubles as a determination condition generation section.

The determination conditions include the PC range of the CPU 111 that corresponds, for example, to a specific processing section. The determination conditions may include the generation of an internal trigger that is initiated, for example, by DMA or a signal input from the outside. The compression circuit generation section 125 may include determination conditions generated as the compression circuit data 202. When the determination section 118 determines that the determination conditions are established, the compression circuit 114a stops the compression circuit 117. This inhibits the output of Want data in a specific processing state where the amount of Must data generation per unit time is not smaller than the threshold value.

### [Operating Procedure]

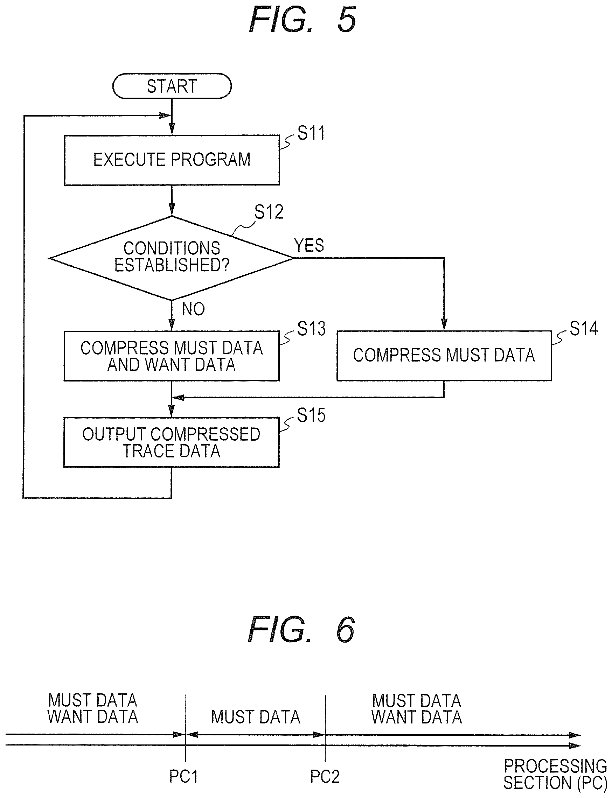

FIG. 5 illustrates an operating procedure performed by the MCU 101 to debug the program. The CPU 111 reads the program 201 from the ROM 112 and executes the program 201 (step S11). The determination section 118 determines whether the determination conditions indicated by the compression circuit data 202 are established (step S12). If, for example, the PC address of the CPU 111 is within a range indicated by the determination conditions, the determination section 118 determines in step S12 that the determination conditions are established. Meanwhile, when a DMA circuit (not depicted) is requested to perform a DMA transfer of a predetermined address range, the determination section 118 determines that the determination conditions are established.

If the determination section 118 determines that the determination conditions are not established, the compression circuits 116, 117 compress Must data and Want data, respectively (step S13). If, by contrast, the determination section 118 determines that the determination conditions are established, the compression circuit 117 stops, and the compression circuit 116 compresses Must data (step S14).

The trace output interface 115 outputs trace data compressed by the compression circuit 114a to the debugging tool 105. When the determination section 118 determines that the determination conditions are not established, the trace output interface 115 outputs, in step S15, the Must data and Want data compressed in step S13. When the determination section 118 determines that the determination conditions are established, the trace output interface 115 outputs the Must data compressed in step S14, but does not output the Want data.

### [Exemplary Operation]

FIG. 6 illustrates an exemplary operation. In FIG. 6, the horizontal axis represents the PC address. For example, the trace data analysis section 124 of the compression circuit optimization section 120 generates an analysis result indicative of an increase in the data amount of Must data in a processing section defined by program counter values of PC1 to PC2. In such an instance, the compression circuit generation section 125 generates determination conditions determining whether the PC address is included in the range of a specific processing section defined by the program counter values of PC1 to PC2. The range of the specific processing section defined by the program counter values of PC1 to PC2 corresponds, for example, to the processing section of a certain function.

If the PC address is not included in the range of the specific processing section when the program 201 is to be debugged, the MCU 101 outputs Must data and Want data from the trace output interface 115. When a specific function is called so that the PC address is PC1, the MCU 101 stops the output (compression) of the Want data, and outputs only the Must data from the trace output interface 115. When processing progresses so that the PC address is greater than PC2, the MCU 101 stops inhibiting the output (compression) of the Want data, and outputs the Must data and the Want data from the trace output interface 115.

### [Summary]

In the present embodiment, the trace data is classified into two types of trace data based on importance. Further, the compression circuit generation section 125 in the present embodiment uses the result of simulation by the program 201 to generate determination conditions for identifying a state where the output of Must data increases, that is, for example, the data amount of Must data drastically increases within a short period of time. If the determination section 118 determines that the determination conditions are not established, the MCU 101 outputs Must data and Want data from the trace output interface 115. If, by contrast, the determination section 118 determines that the determination conditions are established, the MCU 101 outputs only the Must data out of two types of trace data, and stops the output of the Want data.

If the determination section 118 determines that conditions, for example, for drastically increasing the data amount of Must data within a short period of time are established, the present embodiment outputs only highly important Must data and inhibits the output of lowly important Want data. If, by contrast, the determination section 118 does not determine that the determination conditions are established, and thus the bandwidth of the trace output interface 115 is greater than necessary, the trace output interface 115 outputs both the Must data and the Want data. In this manner, when the bandwidth is greater than necessary, both the Must data and the Want data can be acquired. Therefore, debugging can be performed by using both types of trace data. In a situation where a drastic increase in the amount of Must data is anticipated, the loss of Must data can be prevented by inhibiting the output of Want data.

A known related art inhibits the loss of trace data by allowing an MCU to incorporate a buffer for temporarily storing the trace data, and storing the trace data in the buffer when the trace data increases within a short period of time. However, the buffer needs to operate at high speed in order to enable the rapidly operating MCU to inhibit the loss of the trace data. Further, an increase in the capacity of the buffer affects, for example, layout. Therefore, the capacity of a mounted buffer cannot be unlimitedly increased. According to another known related art, the trace data to be acquired is controlled in accordance with the unoccupied capacity of a buffer. However, if the trace data drastically increases, a buffer overflow may occur due, for instance, to a delayed internal operation before the storage of data into the buffer is stopped.

It is difficult for the related arts to determine, during an actual operation, a time point at which the amount of data is maximized. Therefore, an adequate buffer capacity and an adequate communication speed need to be provided in order to constantly cope with an increase in the data amount of trace data. Accordingly, even if the bandwidth of a trace output interface is not fully occupied, the related arts cannot output excess data as the trace data. The present embodiment makes it possible to use the result of simulation in order to grasp a time point at which the data bandwidth of the trace output interface 115 is not fully occupied, and output, at a time point at which the data bandwidth is available, data (Want data) that is not essential to analysis but can be used as reference data. As the Want data can be used for debugging, it is possible to improve the visibility of internal operations of the MCU 101.

### Exemplary Modifications

The foregoing embodiments have been described on the assumption that the compression circuit 114 is configured by using a PLD such as an FPGA. However, the foregoing embodiments are not limited to such a configuration. The compression circuit 114 may be configured to include multiple compression circuits (basic circuits) that compress the trace data by multiple compression methods. In such an instance, the compression circuit generation section 125 may generate parameters indicating which basic circuit is to be used for compression in the compression circuit 114, and generate the compression circuit data 202 including the parameters. When the compression circuit 114 references the parameters included in the compression circuit data 202 and changes the compression operation accordingly, the trace data can be compressed by a compression method appropriate for the program 201.

The second embodiment has been described on the assumption that the compression circuit generation section 125 determines the compression methods of the compression circuits 116, 117 and generates the compression circuit data 202. However, the second embodiment is not limited to such a configuration. In the second embodiment, the compression methods of the compression circuits 116, 117 may be fixed. Even in such an instance, when the bandwidth is greater than necessary, highly important data and lowly important data can be acquired as the trace data by controlling the type of trace data to be outputted depending on whether the determination section 118 determines that the determination conditions are established. Further, when the bandwidth is not greater than necessary, only the highly important data can be acquired as the trace data.

While the present invention contemplated by its inventors has been described in detail in terms of particular embodiments, the present invention is not limited to the foregoing embodiments. It is to be understood by those skilled in the art that various modifications can be made without departing from the scope of the claims.

## Claims

1. A trace data compression method selection device comprising:
a simulator (121) that simulates operations of a semiconductor device (101), the semiconductor device (101) including a processor (111), a compression circuit (114), and a trace interface (115), the compression circuit (114) using a compression method selected from multiple compression methods to compress trace data generated when the processor (111) operates in accordance with a program (201), the trace interface (115) outputting the trace data compressed by the compression circuit (114);
a result analysis section (122) that analyzes the result of execution of the program (201) at the time of simulation and the trace data generated by the simulator (121); and
a compression method decision section (125) that determines the compression method of the compression circuit (114) in accordance with the analysis result of the result of execution of the program (201) and with the analysis result of the trace data, and generates compression circuit data for operating the compression circuit (114) as a circuit that compresses the trace data by the determined compression method.

2. The trace data compression method selection device according to claim 1,
wherein the simulator (121) generates the trace data in accordance with log acquisition conditions.

3. The trace data compression method selection device according to claim 2,
wherein the log acquisition conditions include input information that is supposed to be inputted to the semiconductor device (101) when the semiconductor device (101) executes the program (201).

4. The trace data compression method selection device according to claim 1,
wherein the semiconductor device (101) is a microcontroller unit used for equipment control.

5. The trace data compression method selection device according to claim 1,
wherein the compression circuit (114) includes a reconfigurable device, and
wherein the compression circuit data includes configuration information for operating the reconfigurable device as a circuit that compresses the trace data by the determined compression method.

6. The trace data compression method selection device according to claim 5,
wherein the compression method decision section (125) references a compression circuit library (130) that stores the configuration information in association with each of the compression methods, acquires the configuration information associated with the determined compression method from the compression circuit library (130), and generates the compression circuit data.

7. The trace data compression method selection device according to claim 1,
wherein the result analysis section (122) determines whether a specific value is used multiple times in the trace during the execution of the program (201) at the time of simulation, and
wherein, if the result analysis section (122) determines that the specific value is used multiple times, the compression method decision section (125) determines, as the compression method of the compression circuit (114), a compression method of using a dictionary for storing the specific value and identification information about the specific value in association with each other.

8. The trace data compression method selection device according to claim 1,
wherein the result analysis section (122) analyzes the trend of data width in the trace data that is used in a specific processing section of the program (201), and
wherein, when the result of analysis made by the result analysis section (122) indicates that data having a specific data width is used in the specific processing section, the compression method decision section (125) determines, as the compression method of the compression circuit (114), a compression method of compressing the trace data by changing a data width within the range of a program counter of the processor (111) that corresponds to the specific processing section in accordance with the result of analysis of the trend of the data width.

9. The trace data compression method selection device according to claim 1,
wherein the result analysis section (122) analyzes whether a specific amount of trace data is successively used in a specific processing section of the program (201), and
wherein, when the result of analysis made by the result analysis section (122) indicates that the specific amount of trace data is successively used, the compression method decision section (125) determines, as the compression method of the compression circuit (114), a compression method of compressing the trace data by compressing the specific amount of data by using a predetermined compression algorithm.

10. The trace data compression method selection device according to claim 1,
wherein the trace data includes a timestamp,
wherein the result analysis section (122) determines whether the timestamp can be omitted at a time point other than a time point matching predetermined conditions, and
wherein, when the result analysis section (122) determines that the timestamp can be omitted, the compression method decision section (125) determines, as the compression method of the compression circuit (114), a compression method of compressing the trace data by omitting the timestamp at a time point other than a time point matching the predetermined conditions.

11. The trace data compression method selection device according to claim 1, further comprising:
a data restoration section (140) that restores compressed trace data outputted from the trace interface (115) by a data restoration method compatible with the compression method of the compression circuit (114), the compressed trace data being acquired when the program (201) is executed in the semiconductor device (101).

12. The trace data compression method selection device according to claim 1,
wherein the trace data includes first type trace data and second type trace data, and
wherein the compression circuit (114a) includes a first compression circuit (116) and a second compression circuit (117), the first compression circuit (116) compressing the first type trace data, the second compression circuit (117) compressing the second type trace data.

13. The trace data compression method selection device according to claim 12,
wherein the compression method decision section (125) determines the compression method of the first compression circuit (116) in accordance with the analysis result of the result of execution of the program (201) at the time of simulation and with an analysis result of the first type trace data, and determines the compression method of the second compression circuit (117) in accordance with the analysis result of the result of execution of the program (201) at the time of simulation and with an analysis result of the second type trace data.

14. The trace data compression method selection device according to claim 13,
wherein the semiconductor device (101a) further includes a determination section (118) that determines whether a condition for stopping the output of the second type trace data is established,
wherein the result analysis section (122) determines whether the amount of generation of the first type trace data per unit time in a specific processing state is more than or equal to a threshold value, and
wherein, when the result analysis section (122) determines that the amount of generation of the first type trace data per unit time is more than or equal to the threshold value, the compression method decision section (125) further generates a determination condition associated with the specific processing state, the determination condition being to be set in the determination section (118).

15. The trace data compression method selection device according to claim 14,
wherein the determination condition includes at least either one of the range of a program counter of the processor (201) that corresponds to a specific processing section and the generation of a predetermined internal trigger

16. A trace data compression method selection method comprising the steps of:
simulating operations of a semiconductor device (101), the semiconductor device (101) including a processor (111), a compression circuit (114), and a trace interface (115), the compression circuit (114) using a compression method selected from multiple compression methods in order to compress the trace data generated when the processor (111) operates in accordance with a program (201), the trace interface (115) outputting the trace data compressed by the compression circuit (114);
analyzing the result of execution of the program (201) at the time of simulation;
analyzing the trace data generated by the simulating;
determining the compression method of the compression circuit (114) in accordance with the analysis result of the result of execution of the program (201) and with the analysis result of the trace data; and
generating compression circuit data for operating the compression circuit (114) as a circuit that compresses the trace data by the determined compression method.

17. A computer readable storage medium that causes computer equipment to perform a process including the steps of:
simulating operations of a semiconductor device (101), the semiconductor device (101) including a processor (111), a compression circuit (114), and a trace interface (115), the compression circuit (114) using a compression method selected from multiple compression methods in order to compress the trace data generated when the processor (111) operates in accordance with a program (201), the trace interface (115) outputting the trace data compressed by the compression circuit (114);
analyzing the result of execution of the program (201) at the time of simulation;
analyzing the trace data generated by the simulating;
determining the compression method of the compression circuit (114) in accordance with the analysis result of the result of execution of the program (201) and with the analysis result of the trace data; and
generating compression circuit data for operating the compression circuit (114) as a circuit that compresses the trace data by the determined compression method.

## Patentansprüche

1. Ablaufverfolgungsdatenkompressionsverfahrens-Auswahlvorrichtung, umfassend:
einen Simulator (121), der Operationen einer Halbleitervorrichtung (101) simuliert, wobei die Halbleitervorrichtung (101) einen Prozessor (111), eine Kompressionsschaltung (114) und eine Ablaufverfolgungsschnittstelle (115) enthält, wobei die Kompressionsschaltung (114) ein aus mehreren Kompressionsverfahren ausgewähltes Kompressionsverfahren verwendet, um Ablaufverfolgungsdaten zu komprimieren, die dann erzeugt werden, wenn der Prozessor (111) gemäß einem Programm (201) arbeitet, wobei die Ablaufverfolgungsschnittstelle (115) die durch die Kompressionsschaltung (114) komprimierten Ablaufverfolgungsdaten ausgibt;
einen Ergebnisanalyseabschnitt (122), der das Ergebnis einer Ausführung des Programms (201) zur Zeit einer Simulation und die durch den Simulator (121) erzeugten Ablaufverfolgungsdaten analysiert; und
einen Kompressionsverfahrens-Entscheidungsabschnitt (125), der das Kompressionsverfahren der Kompressionsschaltung (114) gemäß dem Analyseergebnis des Ergebnisses einer Ausführung des Programms (201) und dem Analyseergebnis der Ablaufverfolgungsdaten bestimmt und Kompressionsschaltungsdaten für ein Betreiben der Kompressionsschaltung (114) als Schaltung erzeugt, die die Ablaufverfolgungsdaten durch das bestimmte Kompressionsverfahren komprimiert.

2. Ablaufverfolgungsdatenkompressionsverfahrens-Auswahlvorrichtung nach Anspruch 1,
wobei der Simulator (121) die Ablaufverfolgungsdaten gemäß Protokollerlangungsbedingungen erzeugt.

3. Ablaufverfolgungsdatenkompressionsverfahrens-Auswahlvorrichtung nach Anspruch 2,
wobei die Protokollerlangungsbedingungen Eingabeinformation enthalten, von denen angenommen wird, dass sie zur Halbleitervorrichtung (101) eingegeben wird, wenn die Halbleitervorrichtung (101) das Programm (201) ausführt.

4. Ablaufverfolgungsdatenkompressionsverfahrens-Auswahlvorrichtung nach Anspruch 1,
wobei die Halbleitervorrichtung (101) eine für eine Gerätesteuerung verwendete Mikrosteuerungseinheit ist.

5. Ablaufverfolgungsdatenkompressionsverfahrens-Auswahlvorrichtung nach Anspruch 1,
wobei die Kompressionsschaltung (114) eine rekonfigurierbare Vorrichtung enthält, und
wobei die Kompressionsschaltungsdaten Konfigurationsinformation zum Betreiben der rekonfigurierbaren Vorrichtung als Schaltung enthalten, die die Ablaufverfolgungsdaten durch das bestimmte Kompressionsverfahren komprimiert.

6. Ablaufverfolgungsdatenkompressionsverfahrens-Auswahlvorrichtung nach Anspruch 5,
wobei der Kompressionsverfahrens-Entscheidungsabschnitt (125) auf eine Kompressionsschaltungsbibliothek (130) Bezug nimmt, die die Konfigurationsinformation in Verbindung mit jedem der Kompressionsverfahren speichert, die mit dem bestimmten Kompressionsverfahren verbundene Konfigurationsinformation aus der Kompressionsschaltungsbibliothek (130) erlangt und die Kompressionsschaltungsdaten erzeugt.

7. Ablaufverfolgungsdatenkompressionsverfahrens-Auswahlvorrichtung nach Anspruch 1,
wobei der Ergebnisanalyseabschnitt (122) bestimmt, ob ein spezifischer Wert mehrere Male bei der Ablaufverfolgung während der Ausführung des Programms (201) zur Zeit einer Simulation verwendet wird, und
wobei dann, wenn der Ergebnisanalyseabschnitt (122) bestimmt, dass der spezifische Wert mehrere Male verwendet wird, der Kompressionsverfahrens-Entscheidungsabschnitt (125) als das Kompressionsverfahren der Kompressionsschaltung (114) ein Kompressionsverfahren eines Verwendens eines Wörterbuchs zum Speichern des spezifischen Werts und von Identifikationsinformation über den spezifischen Wert in Verbindung miteinander bestimmt.

8. Ablaufverfolgungsdatenkompressionsverfahrens-Auswahlvorrichtung nach Anspruch 1,
wobei der Ergebnisanalyseabschnitt (122) den Trend einer Datenbreite bei den Ablaufverfolgungsdaten analysiert, die in einem spezifischen Verarbeitungsabschnitt des Programms (201) verwendet werden, und
wobei dann, wenn das Ergebnis einer durch den Ergebnisanalyseabschnitt (122) durchgeführten Analyse anzeigt, dass Daten mit einer spezifischen Datenbreite im spezifischen Verarbeitungsabschnitt verwendet werden, der Kompressionsverfahrens-Entscheidungsabschnitt (125) als das Kompressionsverfahren der Kompressionsschaltung (114) ein Kompressionsverfahren eines Komprimierens der Ablaufverfolgungsdaten durch Ändern einer Datenbreite innerhalb des Bereichs eines Programmzählers des Prozessors (111), der dem spezifischen Verarbeitungsabschnitt entspricht, gemäß dem Ergebnis einer Analyse des Trends der Datenbreite bestimmt.

9. Ablaufverfolgungsdatenkompressionsverfahrens-Auswahlvorrichtung nach Anspruch 1,
wobei der Ergebnisanalyseabschnitt (122) analysiert, ob eine spezifische Menge von Ablaufverfolgungsdaten in einem spezifischen Verarbeitungsabschnitt des Programms (201) aufeinanderfolgend verwendet wird, und
wobei dann, wenn das Ergebnis einer durch den Ergebnisanalyseabschnitt (122) durchgeführten Analyse anzeigt, dass die spezifische Menge von Ablaufverfolgungsdaten aufeinanderfolgend verwendet wird, der Kompressionsverfahrens-Entscheidungsabschnitt (125) als das Kompressionsverfahren der Kompressionsschaltung (114) ein Kompressionsverfahren eines Komprimierens der Ablaufverfolgungsdaten durch Komprimieren der spezifischen Menge von Daten durch Verwenden eines vorbestimmten Kompressionsalgorithmus bestimmt.

10. Ablaufverfolgungsdatenkompressionsverfahrens-Auswahlvorrichtung nach Anspruch 1,
wobei die Ablaufverfolgungsdaten einen Zeitstempel enthalten,
wobei der Ergebnisanalyseabschnitt (122) bestimmt, ob der Zeitstempel zu einem Zeitpunkt weggelassen werden kann, der ein anderer als ein Zeitpunkt ist, der zu vorbestimmten Bedingungen passt, und
wobei dann, wenn der Ergebnisanalyseabschnitt (122) bestimmt, dass der Zeitstempel weggelassen werden kann, der Kompressionsverfahrens-Entscheidungsabschnitt (125) als das Kompressionsverfahren der Kompressionsschaltung (114) ein Kompressionsverfahren eines Komprimierens der Ablaufverfolgungsdaten durch Weglassen des Zeitstempels zu einem Zeitpunkt, der ein anderer als ein Zeitpunkt ist, der zu den vorbestimmten Bedingungen passt, bestimmt.

11. Ablaufverfolgungsdatenkompressionsverfahrens-Auswahlvorrichtung nach Anspruch 1, weiterhin umfassend:
Einen Datenwiederherstellungsabschnitt (140), der von der Ablaufverfolgungsschnittstelle (115) ausgegebene komprimierte Ablaufverfolgungsdaten durch ein Datenwiederherstellungsverfahren wiederherstellt, das mit dem Kompressionsverfahren der Kompressionsschaltung (114) kompatibel ist, wobei die komprimierten Ablaufverfolgungsdaten dann erlangt werden, wenn das Programm (201) in der Halbleitervorrichtung (101) ausgeführt wird.

12. Ablaufverfolgungsdatenkompressionsverfahrens-Auswahlvorrichtung nach Anspruch 1,
wobei die Ablaufverfolgungsdaten Ablaufverfolgungsdaten eines ersten Typs und Ablaufverfolgungsdaten eines zweiten Typs enthalten, und
wobei die Kompressionsschaltung (114a) eine erste Kompressionsschaltung (116) und eine zweite Kompressionsschaltung (117) enthält, wobei die erste Kompressionsschaltung (116) die Ablaufverfolgungsdaten eines ersten Typs komprimiert, wobei die zweite Kompressionsschaltung (117) Ablaufverfolgungsdaten eines zweiten Typs komprimiert.

13. Ablaufverfolgungsdatenkompressionsverfahrens-Auswahlvorrichtung nach Anspruch 12,
wobei der Kompressionsverfahrens-Entscheidungsabschnitt (125) das Kompressionsverfahren der ersten Kompressionsschaltung (116) gemäß dem Analyseergebnis des Ergebnisses einer Ausführung des Programms (201) zur Zeit einer Simulation und einem Analyseergebnis der Ablaufverfolgungsdaten eines ersten Typs bestimmt und das Kompressionsverfahren der zweiten Kompressionsschaltung (117) gemäß dem Analyseergebnis des Ergebnisses einer Ausführung des Programms (201) zur Zeit einer Simulation und einem Analyseergebnis der Ablaufverfolgungsdaten eines zweiten Typs bestimmt.

14. Ablaufverfolgungsdatenkompressionsverfahrens-Auswahlvorrichtung nach Anspruch 13,
wobei die Halbleitervorrichtung (101a) weiterhin einen Bestimmungsabschnitt (118) enthält, der bestimmt, ob eine Bedingung zum Stoppen der Ausgabe der Ablaufverfolgungsdaten eines zweiten Typs eingerichtet ist,
wobei der Ergebnisanalyseabschnitt (122) bestimmt, ob die Menge einer Erzeugung der Ablaufverfolgungsdaten eines ersten Typs pro Einheitszeit in einem spezifischen Verarbeitungszustand mehr als ein oder gleich einem Schwellenwert ist, und
wobei dann, wenn der Ergebnisanalyseabschnitt (122) bestimmt, dass die Menge einer Erzeugung der Ablaufverfolgungsdaten eines ersten Typs pro Einheitszeit mehr als der oder gleich dem Schwellenwert ist, der Kompressionsverfahrens-Entscheidungsabschnitt (125) weiterhin eine Bestimmungsbedingung erzeugt, die mit dem spezifischen Verarbeitungszustand verbunden ist, wobei die Bestimmungsbedingung im Bestimmungsabschnitt (118) einzustellen ist.

15. Ablaufverfolgungsdatenkompressionsverfahrens-Auswahlvorrichtung nach Anspruch 14,
wobei die Bestimmungsbedingung wenigstens eines von dem Bereich eines Programmzählers des Prozessors (201), der einem spezifischen Verarbeitungsabschnitt entspricht, und der Erzeugung eines vorbestimmten internen Auslösers enthält.

16. Ablaufverfolgungsdatenkompressionsverfahrens-Auswahlverfahren, das die folgenden Schritte umfasst:
Simulieren von Operationen einer Halbleitervorrichtung (101), wobei die Halbleitervorrichtung (101) einen Prozessor (111), eine Kompressionsschaltung (114) und eine Ablaufverfolgungsschnittstelle (115) enthält, wobei die Kompressionsschaltung (114) ein aus mehreren Kompressionsverfahren ausgewähltes Kompressionsverfahren enthält, um die Ablaufverfolgungsdaten zu komprimieren, die dann erzeugt werden, wenn der Prozessor (111) gemäß einem Programm (201) arbeitet, wobei die Ablaufverfolgungsschnittstelle (115) die durch die Kompressionsschaltung (114) komprimierten Ablaufverfolgungsdaten ausgibt;
Analysieren des Ergebnisses einer Ausführung des Programms (201) zur Zeit einer Simulation;
Analysieren der durch das Simulieren erzeugten Ablaufverfolgungsdaten;
Bestimmen des Kompressionsverfahrens der Kompressionsschaltung (114) gemäß dem Analyseergebnis des Ergebnisses einer Ausführung des Programms (201) und dem Analyseergebnis der Ablaufverfolgungsdaten; und
Erzeugen von Kompressionsschaltungsdaten zum Betreiben der Kompressionsschaltung (114) als Schaltung, die die Ablaufverfolgungsdaten durch das bestimmte Kompressionsverfahren komprimiert.

17. Computerlesbares Speichermedium, das veranlasst, dass Computergeräte einen Prozess durchführen, der die folgenden Schritte umfasst:
Simulieren von Operationen einer Halbleitervorrichtung (101), wobei die Halbleitervorrichtung (101) einen Prozessor (111), eine Kompressionsschaltung (114) und eine Ablaufverfolgungsschnittstelle (115) enthält, wobei die Kompressionsschaltung (114) ein aus mehreren Kompressionsverfahren ausgewähltes Kompressionsverfahren enthält, um die Ablaufverfolgungsdaten zu komprimieren, die dann erzeugt werden, wenn der Prozessor (111) gemäß einem Programm (201) arbeitet, wobei die Ablaufverfolgungsschnittstelle (115) die durch die Kompressionsschaltung (114) komprimierten Ablaufverfolgungsdaten ausgibt;
Analysieren des Ergebnisses einer Ausführung des Programms (201) zu der Zeit einer Simulation;
Analysieren der durch das Simulieren erzeugten Ablaufverfolgungsdaten;
Bestimmen des Kompressionsverfahrens der Kompressionsschaltung (114) gemäß dem Analyseergebnis des Ergebnisses einer Ausführung des Programms (201) und dem Analyseergebnis der Ablaufverfolgungsdaten; und
Erzeugen von Kompressionsschaltungsdaten zum Betreiben der Kompressionsschaltung (114) als Schaltung, die die Ablaufverfolgungsdaten durch das bestimmte Kompressionsverfahren komprimiert.

## Revendications

1. Un dispositif de sélection de procédé de compression de données de trace comprenant :
un simulateur (121) qui simule des opérations d'un dispositif semi-conducteur (101), le dispositif semi-conducteur (101) comprenant un processeur (111), un circuit de compression (114) et une interface de trace (115), le circuit de compression (114) utilisant un procédé de compression sélectionné parmi plusieurs procédés de compression pour compresser les données de trace générées lorsque le processeur (111) fonctionne conformément à un programme (201), l'interface de trace (115) délivrant les données de trace compressées par le circuit de compression (114) ;
une section (122) d'analyse de résultat qui analyse le résultat de l'exécution du programme (201) au moment de la simulation et les données de trace générées par le simulateur (121) ; et
une section (125) de décision de procédé de compression qui détermine le procédé de compression du circuit de compression (114) conformément au résultat d'analyse du résultat d'exécution du programme (201) et au résultat d'analyse des données de trace, et génère une compression des données de circuit pour faire fonctionner le circuit de compression (114) en tant que circuit qui comprime les données de trace par le procédé de compression déterminé.

2. Le dispositif de sélection de procédé de compression de données de trace selon la revendication 1,
dans lequel le simulateur (121) génère les données de trace en fonction de conditions d'acquisition de journal.

3. Le dispositif de sélection de procédé de compression de données de trace selon la revendication 2,
dans lequel les conditions d'acquisition de journal comprennent des informations d'entrée qui sont censées être entrées dans le dispositif à semi-conducteur (101) lorsque le dispositif à semi-conducteur (101) exécute le programme (201).

4. Le dispositif de sélection de procédé de compression de données de trace selon la revendication 1,
dans lequel le dispositif semi-conducteur (101) est une unité de microcontrôleur utilisée pour une commande d'un équipement.

5. Le dispositif de sélection de procédé de compression de données de trace selon la revendication 1,
dans lequel le circuit de compression (114) comprend un dispositif reconfigurable, et
dans lequel les données du circuit de compression comprennent des informations de configuration pour faire fonctionner le dispositif reconfigurable en tant que circuit qui comprime les données de trace par le procédé de compression déterminé.

6. Le dispositif de sélection de procédé de compression de données de trace selon la revendication 5,
dans lequel la section (125) de décision de procédé de compression fait référence à une bibliothèque (130) de circuits de compression qui stocke les informations de configuration en association avec chacun des procédés de compression, acquiert les informations de configuration associées au procédé de compression déterminé à partir de la bibliothèque (130) de circuits de compression, et génère les données du circuit de compression.

7. Le dispositif de sélection de procédé de compression de données de trace selon la revendication 1,
dans lequel la section (122) d'analyse de résultat détermine si une valeur spécifique est utilisée plusieurs fois dans la trace pendant l'exécution du programme (201) au moment de la simulation, et
dans lequel, si la section (122) d'analyse de résultat détermine que la valeur spécifique est utilisée plusieurs fois, la section (125) de décision de procédé de compression détermine, en tant que le procédé de compression du circuit de compression (114), un procédé de compression consistant à utiliser un dictionnaire pour stocker la valeur spécifique et des informations d'identification concernant la valeur spécifique en association l'une avec les autres.

8. Le dispositif de sélection de procédé de compression de données de trace selon la revendication 1,
dans lequel la section (122) d'analyse de résultat analyse la tendance de la largeur des données dans les données de trace qui sont utilisées dans une section de traitement spécifique du programme (201), et
dans lequel, lorsque le résultat de l'analyse effectuée par la section (122) d'analyse de résultat indique que des données ayant une largeur de données spécifique sont utilisées dans la section de traitement spécifique, la section (125) de décision de procédé de compression détermine, en tant que le procédé de compression du circuit de compression (114), un procédé de compression consistant à compresser les données de trace en modifiant une largeur de données dans la plage d'un compteur de programme du processeur (111) qui correspond à la section de traitement spécifique en fonction du résultat de l'analyse de la tendance de la largeur de données.

9. Le dispositif de sélection de procédé de compression de données de trace selon la revendication 1,
dans lequel la section (122) d'analyse de résultat analyse si une quantité spécifique de données de trace est successivement utilisée dans une section de traitement spécifique du programme (201), et
dans lequel, lorsque le résultat de l'analyse effectuée par la section (122) d'analyse de résultat indique que la quantité spécifique de données de trace est successivement utilisée, la section (125) de décision de procédé de compression détermine, en tant que le procédé de compression du circuit de compression (114), un procédé de compression consistant à compresser les données de trace en compressant la quantité spécifique de données par l'utilisation d'un algorithme de compression prédéterminé.

10. Le dispositif de sélection de procédé de compression de données de trace selon la revendication 1,
dans lequel les données de trace comprennent un horodatage,
dans lequel la section (122) d'analyse de résultat détermine si l'horodatage peut être omis à un instant autre qu'un instant correspondant à des conditions prédéterminées, et
dans lequel, lorsque la section (122) d'analyse de résultat détermine que l'horodatage peut être omis, la section (125) de décision de procédé de compression détermine, en tant que procédé de compression du circuit de compression (114), un procédé de compression consistant à compresser les données de trace en omettant l'horodatage à un instant autre qu'un instant correspondant aux conditions prédéterminées.

11. Le dispositif de sélection de procédé de compression de données de trace selon la revendication 1, comprenant en outre :
une section (140) de restauration de données qui restaure des données de trace compressées émises par l'interface de trace (115) au moyen d'un procédé de restauration de données compatible avec le procédé de compression du circuit de compression (114), les données de trace compressées étant acquises lorsque le programme (201) est exécuté dans le dispositif semi-conducteur (101).

12. Le dispositif de sélection de procédé de compression de données de trace selon la revendication 1,
dans lequel les données de trace comprennent des données de trace d'un premier type et des données de trace d'un deuxième type, et
dans lequel le circuit de compression (114a) comprend un premier circuit de compression (116) et un deuxième circuit de compression (117), le premier circuit de compression (116) comprimant les données de trace du premier type, le deuxième circuit de compression (117) comprimant les données de trace du deuxième type.

13. Le dispositif de sélection de procédé de compression de données de trace selon la revendication 12,
dans lequel la section (125) de décision de procédé de compression détermine le procédé de compression du premier circuit de compression (116) en fonction du résultat d'analyse du résultat d'exécution du programme (201) au moment de la simulation et avec un résultat d'analyse des données de trace du premier type, et détermine le procédé de compression du deuxième circuit de compression (117) en fonction du résultat d'analyse du résultat d'exécution du programme (201) au moment de la simulation et d'un résultat d'analyse des données de trace du deuxième type.

14. Le dispositif de sélection de procédé de compression de données de trace selon la revendication 13,
dans lequel le dispositif semi-conducteur (101a) comprend en outre une section de détermination (118) qui détermine si une condition pour arrêter la sortie des données de trace du deuxième type est établie,
dans lequel la section (122) d'analyse de résultat détermine si la quantité de génération des données de trace du premier type par unité de temps dans un état de traitement spécifique est supérieure ou égale à une valeur de seuil, et
dans lequel, lorsque la section (122) d'analyse de résultat détermine que la quantité de génération des données de trace du premier type par unité de temps est supérieure ou égale à la valeur de seuil, la section (125) de décision de procédé de compression génère en outre une condition de détermination associée à l'état de traitement spécifique, la condition de détermination devant être établie dans la section de détermination (118).

15. Le dispositif de sélection de procédé de compression de données de trace selon la revendication 14,
dans lequel la condition de détermination comprend au moins l'une parmi la plage d'un compteur de programme du processeur (201) qui correspond à une section de traitement spécifique et la génération d'un déclencheur interne prédéterminé.

16. Un procédé de sélection de procédé de compression de données de trace comprenant les étapes consistant à :
simuler des opérations d'un dispositif semi-conducteur (101), le dispositif semi-conducteur (101) comprenant un processeur (111), un circuit de compression (114) et une interface de trace (115), le circuit de compression (114) utilisant un procédé de compression choisi parmi plusieurs procédés de compression afin de compresser les données de trace générées lorsque le processeur (111) fonctionne conformément à un programme (201), l'interface de trace (115) délivrant les données de trace compressées par le circuit de compression (114) ;
analyser le résultat de l'exécution du programme (201) au moment de la simulation ;
analyser les données de trace générées par la simulation ;
déterminer le procédé de compression du circuit de compression (114) conformément au résultat d'analyse du résultat d'exécution du programme (201) et au résultat d'analyse des données de trace ; et
générer des données de circuit de compression pour faire fonctionner le circuit de compression (114) en tant que circuit qui comprime les données de trace par le procédé de compression déterminé.

17. Un support de stockage lisible par ordinateur qui amène un équipement informatique à exécuter un processus comprenant les étapes suivantes :
simuler des opérations d'un dispositif semi-conducteur (101), le dispositif semi-conducteur (101) comprenant un processeur (111), un circuit de compression (114) et une interface de trace (115), le circuit de compression (114) utilisant un procédé de compression choisi parmi plusieurs procédés de compression afin de compresser les données de trace générées lorsque le processeur (111) fonctionne conformément à un programme (201), l'interface de trace (115) délivrant les données de trace compressées par le circuit de compression (114) ;
analyser le résultat de l'exécution du programme (201) au moment de la simulation ;
analyser les données de trace générées par la simulation ;
déterminer le procédé de compression du circuit de compression (114) conformément au résultat d'analyse du résultat d'exécution du programme (201) et au résultat d'analyse des données de trace ; et
générer des données du circuit de compression pour faire fonctionner le circuit de compression (114) en tant que circuit qui comprime les données de trace par le procédé de compression déterminé.
